Europäisches Patentamt

(19) European Patent Office

Office européen des brevets

(11) Publication number: **0 003 659**
A2

(12) **EUROPEAN PATENT APPLICATION**

(21) Application number: 79300163.7

(51) Int. Cl.²: **H 01 J 37/00**

(22) Date of filing: 01.02.79

(30) Priority: 03.02.78 JP 10444/78

(71) Applicant: **Hitachi, Ltd, 1-5-1, Marunouchi, Chiyoda-ku Tokyo (JP)**

(72) Inventor: **Tamura, Hifumi, 10-8 Kiyokawa-cho Hachioji-shi, Tokyo (JP)**
Inventor: **Ishitani, Tohru, 1354-56 Irumagawa, Sayama-shi Saitama-ken (JP)**

(43) Date of publication of application: 22.08.79 Bulletin 79/17

(74) Representative: **Paget, Hugh Charles Edward et al, MEWBURN ELLIS & CO. 70/72 Chancery Lane, London WC2A 1AD (GB)**

(84) Designated Contracting States: DE FR GB

(54) **Apparatus for and method of analysing materials by means of a beam of charged particles.**

(57) The present invention is an ion-electron analyzer consisting in effect of an ion microphobe analyzer and an electron diffractometer which are accommodated in a single housing (5). An electron probe and a negative ion beam are produced simultaneously from the same source (1) of charged particles, and simultaneously bombard the surface of a specimen (6). A mass-spectrograph (7, 8, 9) analyses the secondary ions produced, and a fluorescent screen (13, 14) forms a diffraction pattern from the reflected electrons. In this way one can avoid the disadvantages of the previous separate devices, namely that the specimen is partly destroyed by the ion bombardment so that electron diffraction analysis cannot be performed on the same spot on the specimen and that it is difficult and inconvenient to move the specimen from one device to another.

TITLE MODIFIED
see front page

- 1 -

APPARATUS FOR ANALYSIS OF MATERIALS BY
MEANS OF A BEAM OF CHARGED PARTICLES

The present invention relates to apparatus
for analysis of materials by means of a beam of
charged particles, comprising means for producing
said beam of charged particles and directing the beam
onto the target material and a detector for the
particle stream produced by the bombardment of the
target material by the beam. The invention further
relates to a method of analysis of materials.

In general, determination of the qualitative or quantitative elemental composition of a
sample or analysis of its chemical nature (eg the
binding state of the atoms and molecules) has required
information from more than one source. One type of
apparatus which is capable of obtaining extensive
information for analysing matter consists of a scanning electron microscope which offers an enlarged image of a material while enabling X-ray analysis to be conducted.

An ion microprobe analyser (hereinafter referred to as IMA) has been used for elemental analysis. With a conventional IMA, an ion beam bombards the surface of a specimen in a vacuum, and the resulting secondary ions produced from the atoms of the specimen are analysed in terms of their mass-to-charge ratios using an ordinary mass spectrometer.

However, analysis by means of such an IMA is destructive. The ion bombardment causes sputtering of the surface of the specimen, so that it is worn away in the bombardment direction. As a result it is difficult to analyse the same region of the specimen subsequently by other techniques, for example in order to determine its chemical nature for a full analysis of a surface portion of a specimen, it is necessary to determine what elements are present in that portion, and also the chemical nature, ie, how those elements are bonded together.

A known method of determining the chemical nature uses electron diffraction. In this method, an electron beam impinges on the surface of a specimen, and reflected electrons are detected, eg, by a fluorescent screen, to form an electron diffraction pattern. The pattern is analysed to give information about the chemical nature of the specimen.

By alternately using an IMA and an electron diffraction analyser, it would in theory be possible to carry out the elemental analyses and analyses of the chemical nature at different depths in the same region of a specimen. However, this would involve a large number of cumbersome operations, and each transfer of the specimen from one analyser to the other would require very difficult adjustment to find the same position. Moreover, the surfaces of the specimen would probably come into contact with air during transfer, which might change their chemical nature.

The invention as claimed is intended to overcome the problems of the prior art and to provide apparatus capable of performing combined analytical processes, particularly an analyser which is capable of effecting continuous elemental analysis inwardly from the initial surface of the specimen while simultaneously detecting the chemical nature of the surface momentarily exposed.

The invention as claimed is intended to achieve this object. In essence, it provides apparatus capable of operating simultaneously on a single target as an electron diffraction analyser and an ion microprobe analyser. The ion beam and the electron beam are produced from a common source.

The advantages of the invention include:
(1) that the ions and electron beam can be directed onto the same spot on the specimen, enabling the elemental and chemical structure analyses to be p erformed simultaneously, and (2) that variations of chemical structure and the distribution of elements which may occur with depth can be dynamically observed using erosion caused by the ion beam. Accordingly, the overall characteristics on the surfaces of solid materials, that have hitherto been impossible or difficult to analyze, can be clarified, this presenting potentially great industrial advantages.

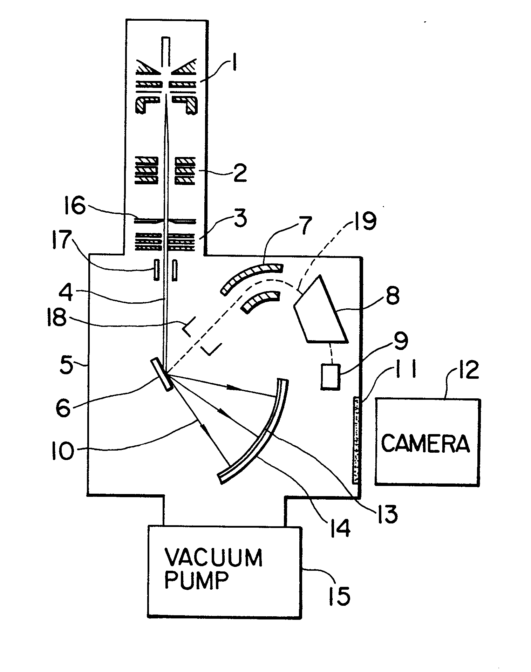

One specific embodiment of the invention will now be described by way of example with reference to the accompanying drawing which is a schematic sectional view of an analyser according to the invention.

The illustrated embodiment uses as its source of charged particles an ion source which utilises plasma. For example, the source may be a duoplasmatron ion gun. A plasma is produced by an electric discharge in a gas, for example, oxygen. The plasma is subjected to a negative 'extraction field' which drives out beams of negative ions (eg of oxygen) and electrons. These beams are converged and collimated by electrostatic lenses 2 and 3 to give narrow beams 4 which extend along the same path and are directed onto the surface of a specimen 6.

Deflectors 17 act to deflect the beams 4 onto any desired place on the specimen 6. An aperture 16 allows only narrow paraxial beams to pass through.

Since the primary ions and the primary electrons are extracted from the plasma by the same extraction voltage and then pass through the same electrostatic lenses 2 and 3, they have the same kinetic energy. Accordingly, the focusing and deflecting effects of the lenses 2 and 3 and the deflector 17 respectively are equal for the ions and the electrons, and do not depend on their masses. Thus the primary ions and the primary electrons have the same focal point and are deflected by the same distance.

The beams 4 bombard the specimen 6 to produce secondary ions 19 and reflected electrons 10. The secondary ions 19 pass through a secondary ion extraction system 18 (which may be a system of electrodes), and are separated according to their mass-to-charge ratios by means of a mass spectrometer made up of a sector electric field 7, a sector magnetic field 8 and a detector 9. This reveals the elements constituting the specimen. The mass spectrometer may be a double-focusing instrument as shown, or a single-focusing mass spectrometer having only the sector magnetic field 8 and not the field 7, or it may be a mass filter utilising a high frequency

0003659

electric field.

The reflected electrons 10 are detected by means of a screen 14 coated with a fluourescent material 13. The resulting electron diffraction pattern is photographed through a glass window 11 by a camera 12. The electron diffraction pattern helps determine the chemical structure of the specimen, ie, the binding state of the elements

The principal portions of the apparatus are enclosed in a vacuum chamber 5 which is evacuated by an evacuation system 15.

A magnetic field deflector may be inserted in the path of the beams 4, eg, attached to the deflector 17. By means of this, the electron beam can be separated from the ion beam so that the specimen can be irradiated by either beam on its own. The magnetic deflector can also be used for scanning. Of course, even without a magnetic deflector, it is possible to utilise only one of the analysis systems by irradiating with both beams and only operating the desired detection system (spectrometer or camera).

Such physical properties of steels as brittleness depend strongly on the segregation of impurities. Thus information about such impurities can be of great value. An example of the use of the invention for analysis of a compound segregated in a steel will now be described.

The electron beam and the ion beam of an analyzer according to the invention were caused to bombard the surface of a micron-polished steel specimen. Analysis of the secondary ions emitted from the specimen proved the segregation of manganese, but did not reveal the chemical form of the manganese in the steel. Analysis of the diffraction image formed by the electrons reflected from the specimen showed that the manganese was present as MnS.

As a second example, use of the invention to analyze a conductive transparent thin film of titanium oxide (TiOx) will now be described.

Conductive transparent thin films of tin oxide ($SnO_2$) have long been used widely. To form such a film it is necessary to maintain the substrate at a temperature higher than 400°C. However, such temperature may damage the substrate. It was therefore desired to develop a method of forming a conductive transparent film at normal temperatures. It was found that a conductive transparent film can be formed by depositing titanium onto the substrate, and then exposing it to an oxygen plasma in order to oxidize the surfaces. A film thus prepared can possess a transparency of 90% and a surface resistivity as little as 50 ohms per square and can exhibit markedly high strength of adhesion to the substrate.

However, it was not known what factors gave the thin film such excellent properties.

We used an analyzer according to the present invention to bombard a substrate bearing such a film with the electron and ion beams and analyzed the mass of the secondary ions emitted from the specimen. It was found that the main components were $Ti^+$ ions and $O^+$ ions with $Cu^+$, $Fe^+$ and $Cr^+$ ions as impurity elements. This showed that a TiOx film had been formed on the surface of the specimen. It was not clear however whether the film was TiO or $TiO_2$. The ion analysis does not give any information about the crystal structure which would help elucidate the mechanism of adhesion of the film to the substrate. Therefore, the electron diffraction pattern was analysed. The diffraction pattern was found to consist of a hollow pattern of small intensity and of diffraction spots of strong intensity arrayed in one direction. Analysis of the pattern proved that the film consisted of fine crystals of a mixture of $TiO_2$, TiO and Ti, the $TiO_2$ being composed of rutile crystals, the a and b axes being arrayed in a random fashion, and the c axis being perpendicular to the surface.

- 9 -                                    0003659

CLAIMS:

(1)      Apparatus for analysis of materials by means of a beam of charged particles, comprising means for producing said beam of charged particles and directing the beam onto the target material and a detector for the particle stream produced by the bombardment of the target material by the beam characterised in that said beam - producing means (1,2,3,16,17) is adapted and arranged to provide simultaneously from the same source of charged particles a primary electron beam and a primary beam of negatively charged ions and to direct both beams onto the target material, there being means (13,14) for forming an electron diffraction pattern from the electrons reflected from the target material and means (7,8,9) for analyzing the masses of the secondary ions produced by the bombardment of the target material by the primary ion beam.

(2)      Apparatus according to Claim 1 characterised in that said electrons and negative ion beams (4) are produced by a duoplasmatron ion gun and are formed into narrow collinated beams by electrostatic lenses (2,3).

(3)      Apparatus according to Claim 1 or Claim 2 characterised in that there are provided deflector electrodes (17) for deflecting said electron and negative ion beams onto a desired location on said target material.

(4)      Apparatus according to any one of Claims
1 to 3 characterised in that said means for forming
the electron diffraction pattern comprises a
fluorescent screen (13,14), there being a camera
(12) to photograph the pattern on the screen.

(5)      Apparatus according to any one of Claims
1 to 4 characterised in that said means for analyzing the masses of the secondary ions comprises
electrodes (18) for extracting the secondary ions,
means (7) providing a sector electric field, means
(8) providing a sector magnetic field, and a
detector (9).

(6)      Method of analysis of material by directing
a beam of charged particles onto the target material
and analyzing the stream of particles so produced,
characterised by directing a beam of electrons and
a beam of negatively charged ions simultaneously
from a single source onto the target material, and
forming an electron diffraction pattern from electrons
reflected from the target material and analyzing the
masses of the secondary ions produced by the ion
bombardment of the target material.